# EUROPÄISCHE PATENTANMELDUNG

(11) **EP 0 833 387 A1**
(43) Veröffentlichungstag der Anmeldung: **01.04.1998**
(21) Anmeldenummer: 97117006.3
(22) Anmeldetag: 30.09.1997
(51) Int. Cl.: H01L 29/739

(54) **Durch Feldeffekt steuerbares Halbleiterbauelement**

(30) Priorität: 30.09.1996 DE 19640307
(71) Anmelder: SIEMENS AKTIENGESELLSCHAFT, 80333 München (DE)
(72) Erfinder: Tihanyi, Jenö, Dr. Ing., 85551 Kirchheim (DE)

(57) **Zusammenfassung**

1. Durch Feldeffekt steuerbares Halbleiterbauelement, bestehend aus einem Halbleiterkörper (1) mit den nachfolgenden Merkmalen:
   a) mit einer Innenzone (2) vom ersten Leitungstyp, die an die erste Oberfläche (3) des Halbleiterkörpers (1) angrenzt,
   b) mit einer Anodenzone (4) vom entgegengesetzten zweiten Leitungstyp, die in Richtung der ersten Oberfläche (3) an die Innenzone (2) angrenzt, und die in der entgegengesetzten Richtung an die zweite Oberfläche (5) angrenzt,
   c) mit mindestens einer ersten Basiszone (7) vom zweiten Leitungstyp, die in der ersten Oberfläche (3) in den Halbleiterkörper (1) eingebettet ist,
   d) mit mindestens einer Sourcezone (8) vom ersten Leitungstyp, die in der ersten Oberfläche (3) in den Halbleiterkörper (1) eingebettet ist,
   e) mit mindestens einer Sourceelektrode (9), die die Basiszonen (7, 16) und die Sourcezonen (8) kontaktieren,
   f) mit mindestens einer Gateelektrode (10), die gegen den Halbleiterkörper (1) und der Sourceelektrode (9) durch ein Gateoxid (11) isoliert sind und mindestens teilweise die an die erste Oberfläche (3) tretenden Teile der ersten Basiszonen (7) überdecken
   g) mit Zwischenzellenzonen (12), die die Sourcezonen (8) enthalten,
   h) mit Trenches (13), die die Zwischenzellenzonen (12) einschließen und gegen die Zwischenzellenzone (12) über ein Gateoxid (11) isoliert sind,
   i) mit Gateelektrodenzapfen (14) in den Trenches (13), die mit der an der ersten Oberfläche (3) verlaufenden Gateelektrode (10) verbunden sind.

## Beschreibung

Die Erfindung betrifft ein durch Feldeffekt steuerbares Halbleiterbauelement, bestehend aus einem Halbleiterkörper mit den folgenden Merkmalen:
a) mit einer Innenzone vom ersten Leitungstyp, die an die erste Oberfläche des Halbleiterkörpers angrenzt,
b) mit einer Anodenzone vom entgegengesetzten zweiten Leitungstyp, die in Richtung der ersten Oberfläche an die Innenzone angrenzt, und die in der entgegengesetzten Richtung an die zweite Oberfläche angrenzt,
c) mit mindestens einer ersten Basiszone vom zweiten Leitungstyp, die in der ersten Oberfläche in den Halbleiterkörper eingebettet ist,
d) mit mindestens einer Sourcezone vom ersten Leitungstyp, die in der ersten Oberfläche in den Halbleiterkörper eingebettet ist,
e) mit mindestens einer Sourceelektrode, die die Basiszonen und die Sourcezonen kontaktieren,
f) mit mindestens einer Gateelektrode, die gegen den Halbleiterkörper und der Sourceelektrode durch ein Gateoxid isoliert sind und mindestens teilweise die an die erste Oberfläche tretenden Teile der ersten Basiszonen überdecken.

Ein Halbleiterbauelement der genannten Art ist als IGBT (Isolated Gate Bipolar Transistor) bekannt und beispielsweise in der Zeitschrift "Elektronik" 9, 1987, Seiten 120 bis 124 beschrieben.

Ferner sind IGBTs mit aus der DRAM-Technologie abgeleiteten Trench-Strukturen bekannt. Der Unterschied zu den eingangs erwähnten IGBTs liegt darin, daß die Gateelektrode durch anisotrope Ätzung (Ätzung in Richtung des Kristallgitters) als V-förmiger oder U-förmiger Graben erzeugt wird, indem die Gateelektrode aus dotiertem Polysilizium oder Metall auf Siliziumdioxid isoliert angeordnet ist. Man erreicht dadurch sehr niedrige Flächenwiderstände und hohe Packungsdichten. Auch ist die nicht-planare Anordnung der Struktur und die starke Abweichung von der in integrierten Schaltkreisen benutzter Herstellungstechnologie nachteilig. Andererseits lassen sich aber bekanntermaßen der Einschaltwiderstand R_{ON} beziehungsweise die Durchlaßspannung V_{SAT} eines IGBT in Trench-Technologie gegenüber den eingangs erwähnten IGBTs dadurch verringern, daß parasitäre JFETs, welche zwischen den Zellen von planaren Transistorstrukturen existieren, prinzipiell wegfallen.

Vorteilhafterweise ist bei IGBTs die Einlaßstelle der Elektronen und der Löcher örtlich getrennt. Dies kann zum Beispiel in der SOI-Technologie (Silicon-On-Insulator) durch eine vergrabene Siliziumdioxid-Schicht erreicht werden.

Der Erfindung liegt die Aufgabe zugrunde, ein Halbleiterbauelement mit Trench-Struktur der eingangs erwähnten Gattung insbesondere einen IGBT so weiterzuentwickeln, daß dieser einen geringen Einschaltwiderstand R_{ON} bei gleichbleibend guten Sperreigenschaften aufweisen. Außerdem soll das Halbleiterbauelement die Parameter eines IGBT mit SOI-Struktur erreichen, ohne daß die aufgezeigten Nachteile einer SOI-Struktur hingenommen werden müssen.

Die Aufgabe wird erfindungsgemäß durch den kennzeichnenden Teil von Patentanspruch 1 gelöst. Es ist hier ein Halbleiterbauelement angegeben
g) mit Zwischenzellenzonen, die die Sourcezonen enthalten,
h) mit Trenches, die die Zwischenzellenzonen einschließen und gegen die Zwischenzellenzonen über ein Gateoxid isoliert sind,
i) mit Gateelektrodenzapfen in den Trenches, die mit den an der ersten Oberfläche verlaufenden Gateelektroden verbunden sind.

Es ist vorteilhaft, wenn ein IGBT einen kleinen Spannungsabfall im eingeschalteten Zustand aufweist. Dazu muß die 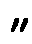 Überflutung" der Anodenzone möglichst hoch sein. Dies kann zum einen erreicht werden, wenn die Fläche der p⁺-Basiszonen, die auf dem Potential O V liegen, möglichst klein ist. Zum anderen ist es vorteilhaft, daß die Einlaßstelle der Elektronen und die Auslaßstelle der Löcher örtlich getrennt sind. Dazu wird ein SOI-ähnlich arbeitender IGBT mit Trench-Strukturen entsprechend dem kennzeichnenden Teil von Patentanspruch 1 beansprucht.

Die Ausgestaltung der Trenches ist Gegenstand von Patentanspruch 2. Vorzugsweise weisen die Trenches die Form von Zapfen auf, die vertikal in den Halbleiterkörper hineinragen. Diese Zapfenstrukturen können mit der aus der DRAM-Technologie gebräuchlichen Trench-Technik realisiert werden, wobei die Vorteile der leicht umzusetzenden Planar-Technologien, wie zum Beispiel die DMOS-Technologie oder SIPMOS-Technologie beibehalten werden.

Die Ausgestaltung der Gateelektroden ist Gegenstand der Patentansprüche 3 und 4. Die Gateelektroden bestehen typischerweise wegen der prozeßtechnisch einfachen Herstellung aus dotiertem Polysilizium. Es sind aber auch andere Materialien für die Gateelektroden, wie zum Beispiel Metall oder Metallsilizid denkbar. Die Gateelektroden sind über ein Gateoxid gegen den Halbleiterkörper isoliert. Als Gateoxid wird wegen seiner prozeßtechnisch einfachen Handhabbarkeit und guten Qualität vorzugsweise thermisches Siliziumdioxid verwendet. Die Gateelektrodenzapfen in den Trenches müssen nicht notwendigerweise mit den lateralen Gateelektroden an der Scheibenvorderseite zusammenhängen. Sie können auch kreisringförmig ausgebildet sein und über einen elektrischen Kontakt mit dem Gateanschluß verbunden sein.

Die Form der Zwischenzellenzonen ist Gegenstand der Patentansprüche 5 und 6. Die Zwischenzellenzonen sind in der Ebene der Scheibenoberfläche vorzugsweise streifenförmig oder kreisringförmig ausgebildet. Die Zwischenzellenzonen können aber auch einen prismenförmigen oder zylinderförmigen Querschnitt aufweisen.

In einer Weiterbildung gemäß Patentansprüche 7 und 8 sind in den Zwischenzellenzonen zweite Basiszonen enthalten. Ein Teil dieser zweiten Basiszonen weisen vorteilhafter Weise eine zapfenförmige Gestalt auf und ragen vertikal von der Scheibenoberfläche in die Zwischenzellenzonen hinein. Die zapfenförmigen Bereiche der zweiten Basiszone weisen eine sehr hohe Dotierungskonzentration auf. Dadurch wird zum einen die Einsatzspannung durch eine p-Ausdiffusion in die Zwischenzellenzone eingestellt. Zum anderen wird die Einlaßstelle der Elektronen und die Auslaßstelle der Löcher örtlich getrennt.

In einer Ausgestaltung gemäß Patentanspruch 9 ist anodenseitig eine hochdotierte Pufferzone vorgesehen. Dadurch ist es möglich, daß die IGBT-Struktur neben der bekannten None-Punch-Through-Version auch in der Punch-Through-Version hergestellt werden kann. Die Pufferzone hat die Aufgabe, den Durchgriff des elektrischen Feldes bei voller Sperrspannung zur Basiszone zu verhindern und die kräftige Injektionswirkung der Basis zu reduzieren.

In einer Ausgestaltung gemäß Patentanspruch 10 ist in der Nähe der Scheibenoberfläche eine floatende Schicht vorgesehen. Bei Anlegen hoher Sperrspannungen können durch die floatende Schicht an den Trenchkanten kritische Feldstärkespitzen vermieden werden, ohne daß im eingeschalteten Zustand die günstige Ladungsträgerverteilung verschlechtert wird. Der Durchbruch des Halbleiterbauelementes ist damit zu höheren Spannung verschoben.

Typische und vorteilhafte Abmessungen und Abstände sind Gegenstand der Patentansprüche 11 bis 14.

Die Erfindung wird nachfolgend anhand der in den Figuren der Zeichnung dargestellten Ausführungsbeispiele näher erläutert. Es zeigt:
- Figur 1: eine perspektivische Ansicht des erfindungsgemäßen Halbleiterbauelements mit Trench-Strukturen,
- Figur 2: einen Schnitt durch ein erfindungsgemäßes Halbleiterbauelement mit Trench-Strukturen, das zusätzlich eine Pufferzone in der Nähe der Scheibenrückseite , eine floatende Schicht in der Nähe der Scheibenvorderseite aufweist und weitere Basiszonen in den Zwischenzellenzonen aufweist,
- Figur 3: eine vorteilhafte Ausführungsform der zweiten Basiszonen in den Zwischenzellenzonen.

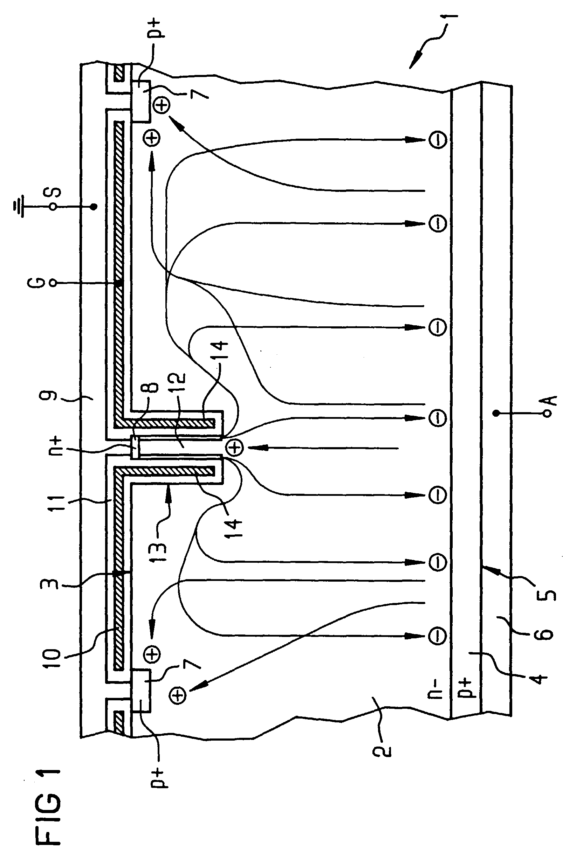

Figur 1 zeigt eine allgemeine Ausführungsform eines erfindungsgemäßen Halbleiterbauelements mit Trench-Strukturen. Insbesondere handelt es sich bei dem Halbleiterbauelement um ein IGBT.

Ein Halbleiterkörper 1, beispielsweise eine Siliziumscheibe, ist n⁻-dotiert. Der unbehandelte n⁻-dotierte Halbleiterkörper 1 wird im folgenden als Innenzone 2 bezeichnet. An der Scheibenrückseite 5 der n⁻-dotierten Innenzone 2 ist eine p⁺-dotierte Anodenzone 4, beispielsweise durch Ionenimplantation, eingebracht worden. Die Anodenzone 4 ist an der Scheibenrückseite 5 über eine übliche Metallisierung großflächig kontaktiert. Diese Metallisierung bildet die Anodenelektrode 6, die mit dem Anodenanschluß A verbunden ist.

An der Scheibenvorderseite 3 sind in der Innenzone 2 p⁺-dotierte Basiszonen 7, beispielsweise durch Ionenimplantation oder Diffusion, eingebettet. Zusätzlich sind an der Scheibenvorderseite 3 Gateelektroden 10 vorgesehen, die über ein Gateoxid 11 gegen den Halbleiterkörper 1 isoliert sind. Als Gateoxid 11 wird bevorzugt wegen seiner prozeßtechnisch einfachen Handhabbarkeit beziehungsweise aus Qualitätsgründen thermisch oxidiertes Siliziumdioxid verwendet. Die Gateelektroden 10 sind lateral über der Scheibenvorderseite 3 so angeordnet, daß sie die Bereiche abdecken, an denen die Innenzone 2 an die Scheibenoberfläche angrenzt. Im Bereich der Basiszonen 7 befinden sich Kontaktlöcher, durch welche die Basiszonen 7 durch eine übliche Metallisierung kontaktiert werden. Diese Metallisierung bildet die Sourceelektrode 9, welche mit dem Sourceanschluß S verbunden ist.

Zusätzlich sind an der Scheibenvorderseite 3 grabenförmige Bereiche vorgesehen. Diese im folgenden als Trenches 13 bezeichneten Bereiche enthalten Gateelektrodenbereiche, die mit den lateralen Gateelektroden 10 an der Scheibenoberfläche verbunden sind. Die Gateelektroden 10 im Bereich der Trenches 13 sind außerdem gegenüber der Innenzone 2 durch ein Gateoxid 11 isoliert. Die Gateelektroden 10 im Bereich der Trenches haben die Form von vertikal in den Halbleiterkörper 1 hineinragender Zapfen und werden im folgenden als Gateelektrodenzapfen 14 bezeichnet. Jeweils zwei benachbarte Trenches 13 beabstanden eine Zwischenzellenzone 12. Die Zwischenzellenzonen 12 weisen vertikal einen säulenartigen Querschnitt auf. Die Zwischenzellenzonen 12 enthalten die Sourcezonen 8. Die Sourcezonen 8 sind n⁺-dotiert und grenzen an die Scheibenoberfläche 3 an. An der Scheibenvorderseite 3 befinden sich im Bereich der Sourcezonen 8 ebenfalls Kontaktlöcher. Über diese Kontaktlöcher werden die Sourcezonen 8 durch die Sourceelektrode 9 kontaktiert.

Die Zwischenzellenzonen 12 sind säulenartig ausgebildet. Die Zwischenzellenzonen 12 können in der Ebene der Scheibenoberfläche streifenförmig, mäanderförmig oder kreisringförmig ausgebildet sein. Es ist aber auch denkbar, daß die Zwischenzellenzonen 12 in der Ebene der Scheibenoberfläche 3 einen irregulären elliptischen oder rechteckigen Querschnitt aufweisen.

Nachfolgend wird die Funktionsweise der IGBT-Struktur entsprechend Figur 1 aufgezeigt. Dabei ist der Elektronenstrom durch Pfeile von der Scheibenvorderseite 3 zum Anodeanschluß A an der Scheibenrückseite 5 dargestellt. Der Löcherstrom wird durch Pfeile in die entgegengesetzte Richtung zum Sourceanschluß S an der Scheibenvorderseite 3 dargestellt.

Wird eine positive Gatespannung an die Gatelektroden 10, 14 gelegt, bildet sich an der Oberfläche der säulenartigen Zwischenzonen 12, die an das Gateoxid 11 angrenzen, ein Stromkanal. Dieser Stromkanal kann durch die Gatespannung moduliert werden. Die Elektronen fließen aus der Säule der Zwischenzellenzone 12 heraus, verteilen sich im ganzen Bereich der Innenzone 2 und fließen dann gleichmäßig zum Anodenanschluß. Die Löcher fließen größtenteils in die p⁺-dotierten Basiszonen 7. Das Ergebnis ist eine gleichmäßig hohe 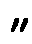 Durchflutung" in der n⁻-dotierten Innenzone, was einen reduzierten Einschaltwiderstand R_{ON} bedeutet.

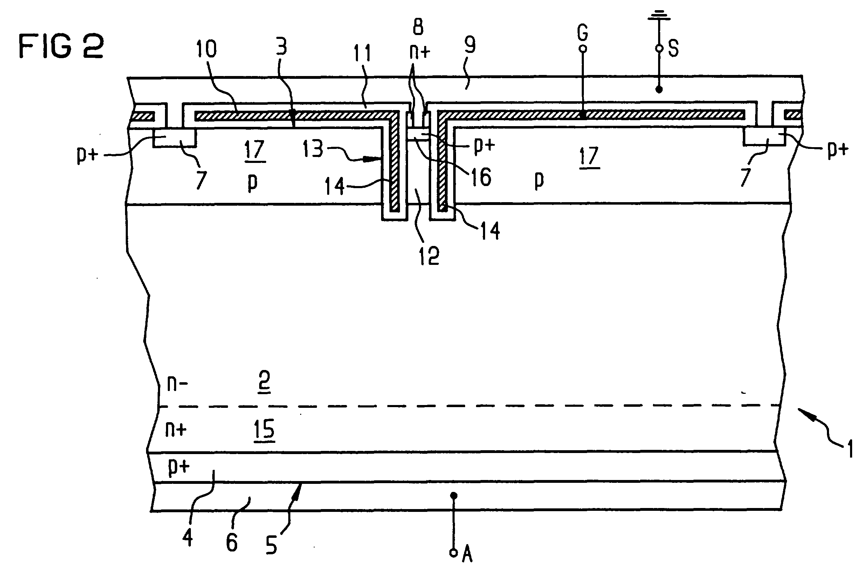

Figur 2 zeigt eine weiterer vorteilhafte Ausgestaltung der erfindungsgemäßen IGBTs entsprechend Figur 1. Gleiche Elemente sind hier mit gleichen Bezugszeichen versehen. Der in Figur 2 gezeigte IGBT ist eine Weiterentwicklung des in Figur 1 gezeigten IGBTs.

Anodenseitig enthält die Innenzone 2 eine dünne n⁺-dotierte Schicht. Diese Schicht wird im folgenden als Pufferzone 15 bezeichnet. Dadurch ist es möglich, die IGBT-Struktur in der bekannten Non-Punch-Through-Version (NPT-Version) entsprechend Figur 1 auch in der Punch-Through-Version (PT-Version) darzustellen. Die Pufferzone hat die Aufgabe, den Durchgriff des elektrischen Feldes bei voller Sperrspannung zur Basiszone zu verhindern und die kräftige Injektionswirkung der Basis zu reduzieren.

In den Zwischenzellenzonen 12 sind zusätzlich zweite Basiszonen 16 vorgesehen. Diese zweiten Basiszonen 16 sind p⁺-dotiert und grenzen an die Sourcezonen 8 an. Zusätzlich werden die zweiten Basiszonen 16 auch durch die Sourceelektrode 9 kontaktiert.

Weiterhin ist in Figur 2 ein p-dotiertes Gebiet 17 vorgesehen. Dieses p-dotierte Gebiet 17 grenzt anodenseitig an die n⁻-dotierte Innenzone 2 an und grenzt sourceseitig an die Scheibenoberfläche beziehungsweise die Basiszonen 7, 16 an. Das p-dotierte Gebiet 17 bildet insbesondere zwischen den Trenchbereichen eine floatende Zone, die auch bei höherer Spannung die Feldstärke reduziert und damit ein vorzeitigen Durchbruch verhindert.

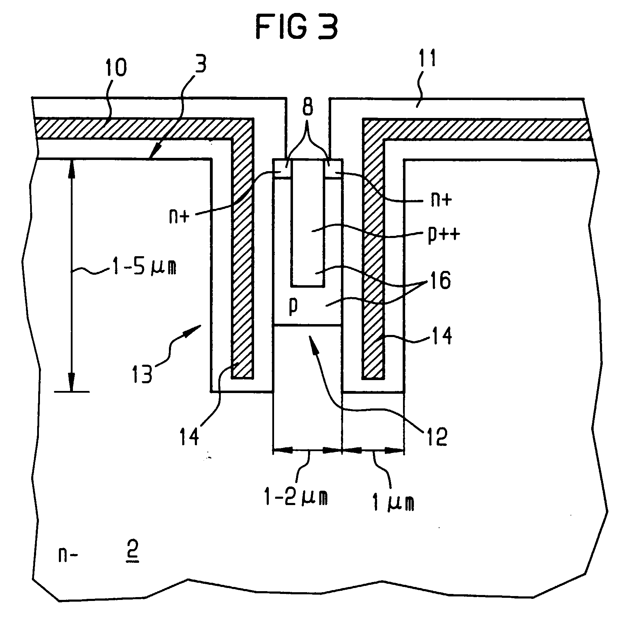

Figur 3 zeigt eine vorteilhafte Ausgestaltung der zweiten Basiszone 16. Gleiche Elemente sind entsprechend Figur 2 mit gleichen Bezugszeichen versehen.

Ein Teil der zweiten Basiszonen 16 in den Zwischenzellenzonen 12 ist zapfenförmig ausgebildet. Diese zapfenförmigen Bereiche der zweiten Basiszonen 16 sind typischerweise p⁺⁺-dotiert und ragen vertikal von der Sourcezone 8 beziehungsweise der Sourceelektrode 9 in den Halbleiterkörper 1 hinein. Die übrigen Bereiche der zweiten Basiszone 16 sind p-dotiert. Die Dotierung dieser Zone kann durch p-Ausdiffusion aus dem p⁺⁺-Basisgebiet erfolgen. Durch diese p-Ausdiffusion ist es zum einen möglich, die Einsatzspannung in den p-dotieren Bereichen der zweiten Basiszone 16 exakt einzustellen. Zum anderen kann die Einlaßstelle der Elektronen und die Auslaßstelle der Löcher durch die zapfenförmige zweite Basiszone 16 örtlich getrennt sein.

In Figur 3 sind außerdem typische Abmessungen und Abstände angegeben. Die Trenches 13 weisen einen Abstand zueinander von typischerweise 1 bis 2µm auf. Die Breite der Trenches 13 beträgt dabei etwa 1µm. Die vertikal grabenförmig in den Halbleiterkörper 1 hineinragenden Trenches 13 weisen typischerweise eine mittlere Tiefe von 1 bis 5 µm auf. Der Abstand der Trenches 13 von den Basiszonen 7 beträgt im Mittel 5 bis 20µm (in Figur 3 nicht dargestellt).

Die Gateelektrodenzapfen 14 in den Trenches 13 müssen nicht notwendigerweise mit den lateralen Gateelektroden 10 an der Scheibenvorderseite 3 zusammenhängen. Sie können auch kreisringförmig ausgebildet sein und über einen elektrischen Kontakt mit dem Gateanschluß G verbunden sein.

Vorteilhafterweise sind die erfindungsgemäßen IGBTs mit npn-MOSFETs entsprechend Figuren 1 und 2 ausgeführt. Diese IGBTs lassen sich einfach steuern beziehungsweise sperren. Es ist auch denkbar die IGBTs mit pnp-MOSFETs auszuführen. Allerdings sind solche IGBTs schwer ausschaltbar.

Die Anforderung an die Oxidschicht, die sowohl die zapfenförmigen Gateelektroden als auch die lateralen Gateelektroden umgeben, sind im Vergleich zu den chemischen beziehungsweise elektrodynamischen Anforderungen an das Gateoxid 11 nicht so hoch. Es ist demnach auch denkbar, hier Spin-On-Glas beziehungsweise andere chemische Verfahren einzusetzen, die relativ lose gepackte Oxidschichten ergeben mit geringerer Dichte und demnach geringerer Dielektrizitätskonstante.

### Bezugszeichenliste

- 1: Halbleiterkörper
- 2: Innenzone
- 3: erste Oberfläche, Scheibenvorderseite
- 4: Anodenzone
- 5: zweite Oberfläche, Scheibenrückseite
- 6: Anodenelektrode
- 7: (erste) Basiszonen
- 8: Sourcezone
- 9: Sourceelektrode
- 10: Gateelektrode
- 11: Gateoxid
- 12: Zwischenzellenzonen
- 13: Trenches
- 14: Gateelektrodenzapfen
- 15: Pufferzone
- 16: zweite Basiszonen
- 17: floatende Schicht
- A: Anodenanschluß
- S: Sourceanschluß
- G: Gateanschluß

## Patentansprüche

1. Durch Feldeffekt steuerbares Halbleiterbauelement, bestehend aus einem Halbleiterkörper (1)
a) mit einer Innenzone (2) vom ersten Leitungstyp, die an die erste Oberfläche (3) des Halbleiterkörpers (1) angrenzt,
b) mit einer Anodenzone (4) vom entgegengesetzten zweiten Leitungstyp, die in Richtung der ersten Oberfläche (3) an die Innenzone (2) angrenzt, und die in der entgegengesetzten Richtung an die zweite Oberfläche (5) angrenzt,
c) mit mindestens einer ersten Basiszone (7) vom zweiten Leitungstyp, die in der ersten Oberfläche (3) in den Halbleiterkörper (1) eingebettet ist,
d) mit mindestens einer Sourcezone (8) vom ersten Leitungstyp, die in der ersten Oberfläche (3) in den Halbleiterkörper (1) eingebettet ist,
e) mit mindestens einer Sourceelektrode (9), die die Basiszonen (7, 16) und die Sourcezonen (8) kontaktieren,
f) mit mindestens einer Gateelektrode (10), die gegen den Halbleiterkörper (1) und der Sourceelektrode (9) durch ein Gateoxid (11) isoliert sind und mindestens teilweise die an die erste Oberfläche (3) tretenden Teile der ersten Basiszonen (7) überdecken
**gekennzeichnet durch**
g) Zwischenzellenzonen (12), die die Sourcezonen (8) enthalten,
h) Trenches (13), die die Zwischenzellenzonen (12) einschließen und gegen die Zwischenzellenzone (12) über ein Gateoxid (11) isoliert sind,
i) Gateelektrodenzapfen (14) in den Trenches (13), die mit der an der ersten Oberfläche (3) verlaufenden Gateelektrode (10) verbunden sind.

2. Durch Feldeffekt steuerbares Halbleiterbauelement nach Anspruch 1,
**dadurch gekennzeichnet,**
daß die Trenches (13) zapfenförmig ausgebildet sind und vertikal von der ersten Oberfläche (3) in den Halbleiterkörper (1) hineinragen.

3. Durch Feldeffekt steuerbares Halbleiterbauelement nach einem der Ansprüche 1 bis 2,
**dadurch gekennzeichnet,**
daß die Gateelektroden (10, 14) mindestens teilweise aus dotiertem Polysilizium, Metall oder Metallsilizid bestehen.

4. Durch Feldeffekt steuerbares Halbleiterbauelement nach einem der Ansprüche 1 bis 3,
**dadurch gekennzeichnet,**
daß das Gateoxid (11) Siliziumdioxid ist.

5. Durch Feldeffekt steuerbares Halbleiterbauelement nach einem der Ansprüche 1 bis 4,
**dadurch gekennzeichnet,**
daß die Zwischenzellenzonen (12) in der Ebene der ersten Oberfläche (3) streifenförmig, mäanderförmig oder kreisringförmig ausgebildet sind.

6. Durch Feldeffekt steuerbares Halbleiterbauelement nach einem der Ansprüche 1 bis 4,
**dadurch gekennzeichnet,**
daß die Zwischenzellenzonen (12) in der Ebene der ersten Oberfläche (3) prismenförmig oder zylinderförmig ausgebildet sind.

7. Durch Feldeffekt steuerbares Halbleiterbauelement nach einem der Ansprüche 1 bis 6,
**dadurch gekennzeichnet,**
daß die Zwischenzellenzonen (12) zweite Basiszonen (16) vom zweiten Leitungstyp enthalten, die an die erste Oberfläche (3) des Halbleiterkörpers (1) angrenzen.

8. Durch Feldeffekt steuerbares Halbleiterbauelement nach Anspruch 7,
**dadurch gekennzeichnet,**
daß mindestens ein Teil der in den Zwischenzellenzonen (12) gelegenen zweiten Basiszonen (16) die Form von Zapfen aufweist, wobei die zapfenförmigen Bereiche der zweiten Basiszone (16) vertikal von der ersten Oberfläche (3) in die Zwischenzellenzonen (12) hineinragen.

9. Durch Feldeffekt steuerbares Halbleiterbauelement nach einem der Ansprüche 1 bis 8,
**dadurch gekennzeichnet,**
daß die Innenzone (2) anodenseitig eine Pufferzone (15) vom selben Leitungstyp enthält, wobei die Pufferzone (15) eine Dotierungskonzentration aufweist, die mindestens um den Faktor 10 größer ist als die Dotierungskonzentration der Innenzone (2).

10. Durch Feldeffekt steuerbares Halbleiterbauelement nach einem der Ansprüche 1 bis 9,
**dadurch gekennzeichnet,**
daß zwischen erster Oberfläche (3) und Innenzone (2) eine floatende Schicht (16) vom zweiten Leitungstyp vorgesehen ist, deren Dotierungskonzentration mindestens um den Faktor 10 kleiner ist als die Dotierungskonzentration in den Basiszonen (7, 16).

11. Durch Feldeffekt steuerbares Halbleiterbauelement nach einem der Ansprüche 1 bis 10,
**dadurch gekennzeichnet,**
daß die Zwischenzellenzonen (12) lateral eine Breite von 1 bis 2µm aufweisen.

12. Durch Feldeffekt steuerbares Halbleiterbauelement nach einem der Ansprüche 1 bis 11,
**dadurch gekennzeichnet,**
daß die Trenches (13) etwa 1 bis 5µm von der ersten Oberfläche (3) aus in den Halbleiterkörper (1) hineinragen.

13. Durch Feldeffekt steuerbares Halbleiterbauelement nach einem der Ansprüche 1 bis 12,
**dadurch gekennzeichnet,**
daß die Trenches (13) lateral eine Breite von etwa 1µm aufweisen.

14. Durch Feldeffekt steuerbares Halbleiterbauelement nach einem der Ansprüche 1 bis 13,
**dadurch gekennzeichnet,**
daß die Trenches (13) einen Abstand von 5 bis 20µm zu den ersten Basiszonen (7) aufweisen.
